# EUROPEAN PATENT APPLICATION

(11) **EP 1 156 536 A2**
(43) Date of publication of application: **21.11.2001**
(21) Application number: 01201639.0
(22) Date of filing: 07.05.2001
(51) Int. Cl.: H01L 51/20

(54) **Method of using predoped materials for making an organic light-emitting device**

(30) Priority: 19.05.2000 US 574532
(71) Applicant: EASTMAN KODAK COMPANY, Rochester, New York 14650 (US)
(72) Inventor: Shi, Jianmin, Rochester, New York 14650-2201 (US)
(74) Representative: Lewandowsky, Klaus, Dipl.-Ing.

(57) **Abstract**

A method of depositing a predoped organic light emitting material to form a layer in an organic light-emitting device, includes providing a homogeneous solid mixture capable of being deposited which includes at least one organic light-emitting host material and at least one luminescent organic dopant material; and depositing the homogeneous solid mixture to form a layer in an organic light emitting device.

## Description

The present invention relates generally to organic light-emitting devices and, more particularly, to a method of making such devices using predoped organic materials.

Organic light-emitting devices, also referred to as organic electroluminescent (EL) devices or as organic internal junction light-emitting devices, contain spaced electrodes separated by an organic light-emitting structure (also referred to as an organic EL-medium) which emits electromagnetic radiation, typically light, in response to the application of an electrical potential difference across the electrodes. The organic light-emitting structure must not only be capable of producing light efficiently, but must be capable of fabrication in a continuous form (that is, must be free of pinholes and particle defects) and must be sufficiently stable to facilitate fabrication and to support operation.

Initially organic EL devices were fabricated using single crystals of organic materials, as illustrated in US-A-3,530,325, and US-A-3,621,321. Single organic crystal EL devices were relatively difficult to fabricate and further did not readily lend themselves to thin film constructions.

In recent years, preferred organic EL devices have been constructed employing thin film deposition techniques. Using an anode as a device support, the organic EL-medium has been deposited as a combination of thin films followed by the deposition of a cathode, also formed by thin film deposition. Thus, starting with the anode structure, it is possible to form the entire active structure of an organic EL device by thin film deposition techniques. As employed herein, the term "thin film" refers to layer thicknesses of less than 5 µm, with layer thicknesses of less than about 2 µm being typical.

The combination of thin films forming the organic EL-medium includes at least an organic hole-transporting layer in contact with the anode, and an organic electron-transporting layer disposed over the hole-transporting layer and in contact with the cathode. Light is emitted from an internal junction at or near an interface between the organic layers upon application of an electrical potential between the anode and the cathode such that the cathode is at a more negative potential than the anode. The emitted light has a spectral distribution of wavelengths which is governed by molecular characteristics of the materials selected for forming the organic electron-transporting and hole-transporting layers.

The color or hue, that is, the spectral distribution, of emitted light can be modified by introducing a "dopant" into the electron-transporting layer during its thin film deposition, such that a doped light-emitting zone will be formed at or near the interface between the electron-transporting and hole-transporting layers. Such dopants are luminescent materials which are stimulated to emit light which is characterized by the luminescent material, upon excitation by the light which would be generated at the interface-junction of the undoped layer structure.

Similarly, when the organic EL-medium is constructed of three or more organic thin films, an organic light-emitting thin film may be formed as a doped layer disposed between the organic hole-transporting layer and the organic electron-transporting layer.

The efficiency of light-emission from a doped light-emitting layer or from a doped light-emitting zone of a layer can be substantially influenced by selection of an organic host material, selection of an organic dopant material, the concentration of the dopant in the layer of the host material, and the degree of uniformity with which the dopant can be "molecularly dispersed" within the layer of the host material. Under appropriate consideration of these factors, an efficient organic light-emitting device can be constructed which has a luminescent dopant uniformly dispersed throughout an organic light-emitting layer at a dopant concentration in a range from about 0.01 mole percent to a few mole percent, typically in a range of 0.01 mole percent to 1 mole percent.

Doped light-emitting layers of prior art organic light-emitting devices have been formed by co-deposition from two independently controlled evaporation deposition sources, namely a deposition source providing the host material and a deposition source providing the dopant material. In a evaporation deposition process useful for forming a doped organic light-emitting layer, the concentration of the luminescent dopant in the host-layer being formed was controlled by controlling the rate of evaporation of the dopant material from the dopant deposition source and by controlling the rate of evaporation deposition of the host material from the host deposition source. Such independently controlled co-deposition has been effective in producing doped organic light-emitting devices of acceptable efficiency of light-emission in a research and device development environment. However, there are at least two disadvantages of the aforementioned co-deposition process:
(i) it has been difficult to precisely control the deposition rates (of the host material and of the dopant material), particularly when relatively low concentration levels of 0.01 to 0.1 mole percent of dopant were to be incorporated in a doped layer of a host material; and
(ii) co-deposition is relatively wasteful in terms of material utilization in that each of the evaporation co-deposition sources must be activated and adjusted to a desired vapor flux prior to the onset of layer formation over a previously formed organic layer of the device. Usually, a mechanical shutter is used to protect the device until such time as required to adjust the vapor flux of the host material and the vapor flux of the dopant material. Waste of such materials not only increases the cost of a device, but also increases the difficulty of maintenance of a evaporation deposition system.

It is an object of the present invention to provide a method of making a predoped organic layer that minimizes the disadvantages of the prior art listed above.

This object is achieved in a method of depositing a predoped organic light emitting material to form a layer in an organic light-emitting device, comprising the steps of:
(a) providing a homogeneous solid mixture capable of being deposited which includes at least one organic light-emitting host material and at least one luminescent organic dopant material; and
(b) depositing the homogeneous solid mixture to form a layer in an organic light emitting device.

The present invention has an advantage in that it uses a single evaporation deposition source. By using a single evaporation deposition source an organic predoped layer can be formed in an organic light-emitting device that is consistent from device to device. Moreover, by using a single evaporation deposition source a predoped organic material from a single evaporation deposition source provides an effective way for forming an organic light-emitting layer with a selected dopant concentration.
FIG. 1 is a schematic cross-section of an organic light-emitting device in which light is emitted through an anode and a substrate, and having a doped light-emitting layer;
FIG. 2 is a schematic illustration of a vacuum evaporation deposition system shown in a prior art configuration in which two independently controlled evaporation deposition sources are used to form a doped light-emitting layer; and
FIG. 3 is a schematic illustration of a vacuum evaporation deposition system shown in a configuration in which a single evaporation deposition source is used to form a doped light-emitting layer from a predoped organic light-emitting material.

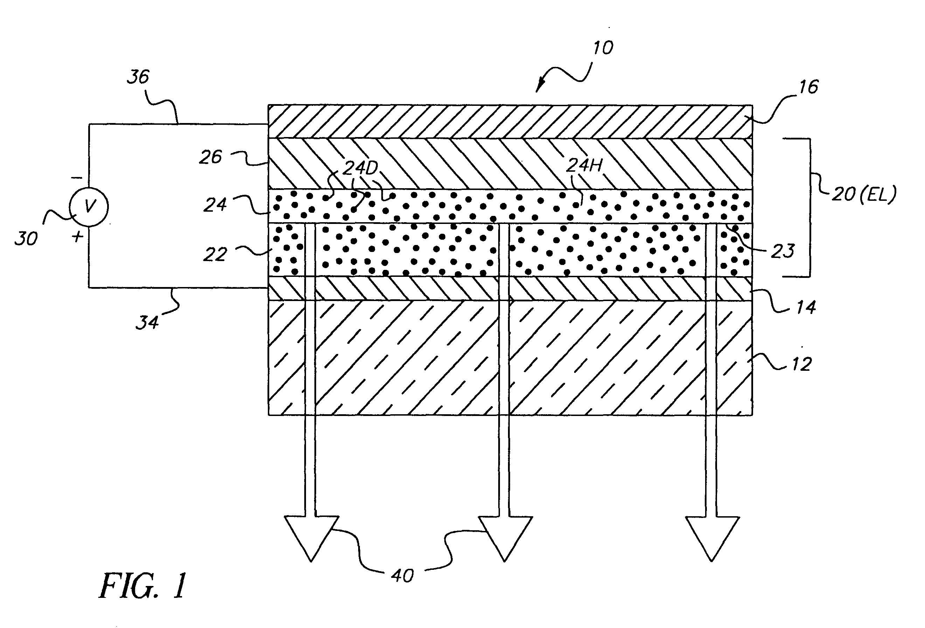

FIG. 1 is an illustrative example of an organic light-emitting device 10 which has a light-transmissive substrate 12 on which is formed a light-transmissive hole-injecting anode 14. Substrate 12 can be glass or quartz, and the anode 14 is preferably a thin layer of indium tin oxide (ITO) formed over the substrate 12. An organic EL-medium structure 20 is comprised of an organic hole-transporting layer 22 which is formed over the anode 14, an organic light-emitting layer 24, and an organic electron-transporting layer 26. An electron-injecting cathode 16 is formed over the electron-transporting layer 26.

The light-emitting layer 24 is comprised of at least one organic light-emitting host material 24H, and at least one luminescent dopant material 24D finely dispersed within the host material 24H at a selected concentration. The host material 24H of the light-emitting layer 24 is capable of transporting electrons therethrough, as is the electron-transporting layer 26. An interfacial light-emitting junction 23 is formed at or near an interface between the hole-transporting layer 22 and the light-emitting layer 24.

The organic light-emitting device 10 is operated by applying an electrical potential between the electron-injecting cathode 16 and the hole-injecting anode 14 such that the cathode 16 is at a more negative potential with respect to the anode 14. In this case, electrons (negative charge carriers) are injected from the cathode 16 into the electron-transporting layer 26. Simultaneously, holes (positive charge carriers) are injected from the anode 14 into the organic hole-transporting layer 22. The electrons and holes recombine at or near the internal junction 23. This electron-hole recombination results in light emission from a region near the junction 23. The electrical potential is provided by a drive voltage source 30 which is connected to the cathode 16 by a lead 36, and connected to the anode 14 by a lead 34. The drive voltage source 30 can be a dc voltage source, a pulsed voltage source, or an ac voltage source. Under the drive voltage source conditions depicted in FIG. 1, emitted light 40 is indicated schematically as originating at or near the junction 23, and being transmitted through the hole-transporting layer 22, the light-transmissive anode 14, and the light-transmissive substrate 12, to be directed toward a viewer.

The color or hue of the emitted light 40 can be selected by incorporating at least one luminescent organic dopant material 24D in the host material 24H of the light-emitting layer 24. The at least one light-emitting host material 24H is selected to provide, in the absence of the dopant material 24D, light emission in a spectral region, such as, for example, in a blue region of the visible spectrum. In the presence of the luminescent dopant material 24D, energy corresponding to light emission from the host material 24H is transferred to the dopant material 24D which then emits light in a spectral region characteristic of the luminescent dopant material 24D, generally in a spectral region corresponding to lower energy such as, for example, light in a green spectral region or light in a yellow spectral region or light in a red spectral region.

The organic materials from which the layers 22, 24, and 26 of the EL-medium structure 20 are formed can be selected from among materials, configurations of layers, and preferred layer thicknesses of conventional organic light-emitting devices such as those described in commonly-assigned US-A-4,356,429; US-A-4,539,507; US-A-4,720,432; US-A-4,885,211; US-A-4,769,292; US-A-5,047,687; US-A-5,059,862; and US-A-5,061,569, the disclosures of which are herein incorporated by reference. Organic light-emitting host materials particularly preferred in the practice of the invention have been described in commonly-assigned US-A-5,935,721, and US-A-5,972,247, the disclosures of which are herein incorporated by reference.

The organic layers 22, 24, 26, as well as the electron-injecting cathode 16 can be formed by well known evaporation deposition techniques.

With particular reference to the light-emitting layer 24, includes at least one organic light-emitting host material 24H and at least one luminescent dopant material 24D, the evaporation deposition of such doped light-emitting layer will now be described as a prior art method of evaporation deposition.

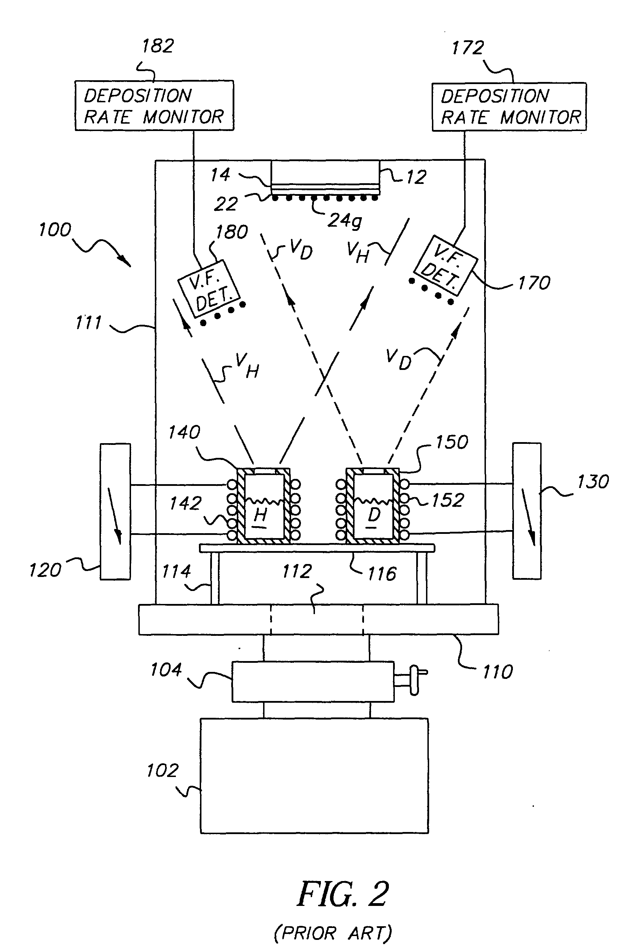

Turning to FIG. 2, a evaporation deposition system 100 has a base plate 110 and a chamber 111 which has feed-throughs (not shown) for connecting elements located within the chamber 111 to elements or parts located outside the chamber. A vacuum pump 102 is used to evacuate the inside of the chamber 111 via a valve 104 and a pumping port 112 disposed in the base plate 110, for example, to a base pressure of 10⁻⁶ Torr. A platform 116 is spaced from the base plate 110 by spacers 114. A host material evaporation source 140 containing a host material H is positioned on the platform 116, and a dopant material evaporation source 150, containing a dopant material D is positioned on the same platform 116. The host material evaporation source 140 is schematically depicted as a container having heating elements 142 disposed on an outside thereof, the heating elements 142 being connected to a power source 120 which can be regulated to provide for heating the heating elements 142, and therefore heating the host material within the evaporation source 140 to a temperature at which the host material H will evaporate (usually by a process known as sublimation) to provide the vapor streams indicated at V_{H} in dashed outline. The host vapor stream V_{H} is detected by a vapor flux detector 180, and is indicated on a deposition rate monitor 182.

The dopant material evaporation source 150 is surrounded on an outside thereof by heating elements 152 which are connected to a power source 130, regulated to heat the elements 152, and therefore the dopant material D to a temperature at which the dopant material will evaporate (usually by a sublimation process) to provide the dopant vapor streams indicated at V_{D} in dotted outline. The dopant vapor stream V_{D} is measured by a vapor flux detector 170, and is displayed on a deposition rate monitor 172.

The vapor streams V_{H} and V_{D} overlap in a central region within the chamber 111, and a substrate 12 is disposed within this overlap region on an upper surface of the chamber 111. The substrate 12 has the anode 14 and a previously formed hole-transporting layer 22, as described with reference to FIG. 1. A growing light-emitting layer 24g is indicated schematically as being formed over the hole-transporting layer 22.

It will be appreciated that each of the power sources 120 and 130 have to be adjusted so that the vapor stream V_{D} will correspond to a selected concentration of the dopant(s) D in the host material(s) H of the growing light-emitting layer 24g in this evaporation co-deposition from two independently controlled evaporation sources. Such control has been difficult to achieve reliably, particularly at relatively low desired dopant concentrations in a range of 0.01 to 0.5 mole percent.

The evaporation sources 140 and 150 are merely illustrative examples, and numerous different configurations of such evaporation sources are well known to those skilled in the art of forming layers by evaporation deposition. Equally well known is the incorporation of a shutter (not shown) which covers the substrate during such time as is required to establish stable vapor streams V_{H} and V_{D}, such shutter being then opened to provide deposition of the doped light-emitting layer.

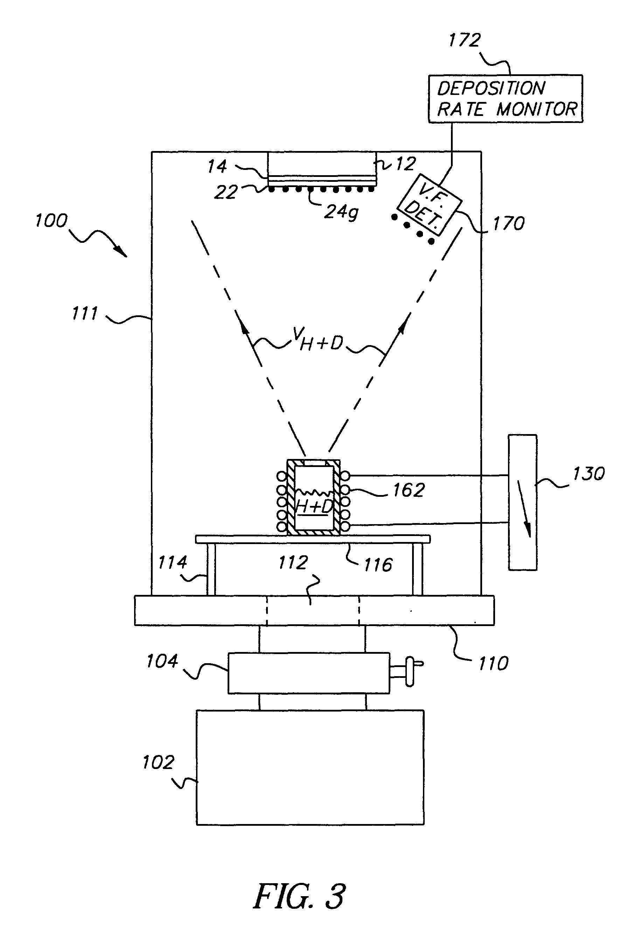

Turning to FIG. 3, an evaporation deposition system 100 is substantially identical to the system described with reference to FIG. 2. Accordingly, like numeral designations correspond to like parts, and the system 100 of FIG. 3 will require no further description of such like parts.

Here, the evaporation deposition system 100 has only a single evaporation source 160 for containing a homogeneous mixture of a predoped material, designated at H+D. The evaporation source 160 is surrounded by heating elements 162 which are connected to an adjustable power source 130 for heating the elements 162, and therefore the predoped material H+D to a temperature at which the predoped material will evaporate, as indicated by the vapor streams V_{H+D} shown in dashed and dotted outline. The vapor streams V_{H+D} are detected by a vapor flux detector 170, and displayed on a deposition rate monitor 172.

The homogeneous mixture H+D can contain one or more host materials H and one or more luminescent dopant materials D, each of which are selected to provide a light-emitting layer capable of producing emission of light having a selected color or hue, that is capable of light emission in a selected spectral region.

Forming a doped light-emitting layer by evaporation deposition from a single evaporation source eliminates the evaporation control problems associated with co-deposition from two independently controlled evaporation sources described previously with reference to FIG. 2.

As is well known in the field of fractional distillation of two or more components of a mixture, separation of such components by sublimation (evaporation) is virtually impossible if the vapor pressure of each of the components of the mixture is identical or close.

The present invention of using a homogenous mixture of one or more organic light-emitting host materials and of one or more organic luminescent dopant materials is based on the above knowledge. Accordingly, one or more organic light-emitting host materials and one or more organic luminescent dopant materials are selected for forming a homogeneous mixture on the basis of relatively closely matched evaporation temperature.

It has been found that organic light-emitting layers can be formed reproducibly by evaporation deposition from a single evaporation source, of a homogeneous mixture of at least one organic light-emitting host material and at least one luminescent organic dopant material. There can be one or more host components, each host component having a predetermined evaporation temperature T and one or more organic light-emitting dopant material, each organic light-emitting dopant material having an evaporation temperature in a range of from (T-40)°C to (T+40)°C. Ideally, evaporation temperatures of each component of the mixture is equal to the evaporation temperatures of the pure substances, multiplied by the mole percentage of the dopant in the host material.

A homogenous mixture of a light-emitting host material and a luminescent dopant material can be prepared by mixing a measured quantity of each solid material and placing the mixture into a container which can be provided with a chemically inert environment, such as, for example, an inert gas. The mixture is then melted in the container to provide the homogeneous mixture. Upon cooling to ambient temperature, the homogeneous mixture of host material and dopant is removed from the container, and a portion of the homogeneous mixture is placed in the evaporation source 160 for sublimation or evaporation therefrom so as to form the growing light-emitting layer 24g over the organic hole-transporting layer 22. A preferred concentration of the dopant material in the host material is in a range from 0.05 to 5.0 mole percent.

Alternatively, a homogeneous mixture of at least one organic light-emitting host material and at least one organic luminescent dopant material can be formed by dissolving a measured quantity of each of the materials in a common solvent or in a combination of solvents, placing the solution into a container which permits controlled removal of the solvent or solvents, whereupon a portion of the homogeneous mixture is removed from the container and placed into the evaporation source 160 for sublimation or evaporation therefrom.

While the above detailed description has been directed at using a predoped organic light-emitting material for forming a doped light-emitting layer in an organic light-emitting device, the present invention is not limited to providing and using predoped organic light-emitting materials.

The present invention includes providing and using predoped organic hole-transporting materials and predoped organic electron-transporting materials in forming a doped organic hole-transporting layer and a doped organic electron-transporting layer, respectively, in an organic light-emitting device.

Predoping an organic hole-transporting material and/or an organic electron-transporting material has, as a primary purpose, the improvement of physical aspects of doped organic layers formed therefrom. For example, a doped organic hole-transporting layer and/or a doped organic electron-transporting layer formed from respective predoped materials by evaporation deposition from a single evaporation source, can have one or more of the following advantageous features in an organic light-emitting device:
(i) reduced number of pin-hole defects;
(ii) improved charge-transporting properties;
(iii) improved temperature tolerance during device operation;
(iv) improved stability during device operation and during device storage; and
(v) improved amorphous features of such layers.

Predoped organic hole-transporting materials are provided by forming a solid homogeneous mixture of a selected quantity of at least one organic hole-transporting host material and of a selected quantity of at least organic hole-transporting dopant material. The quantities are selected to provide a homogeneous mixture having a dopant material concentration in the host material in a preferred range from 1.0 to 50 mole percent. The hole-transporting host material includes one or more host components, each host component having a predetermined evaporation temperature T and one or more organic dopant material, each organic dopant material having an evaporation temperature in a range of from (T-40)°C to (T+40)°C.

The solid homogeneous mixture of predoped organic hole-transporting material is then used in the evaporation source 160 (see FIG. 3) for sublimation or evaporation therefrom to form a doped organic hole-transporting layer over an anode.

Analogously, a predoped organic electron-transporting material can be provided by forming a solid homogeneous mixture of a selected quantity of at least one organic electron-transporting host material and of a selected quantity of at least one organic electron-transporting dopant material. The quantities are selected to provide a homogeneous mixture having a dopant material concentration in the host material in a preferred range from 1.0 to 50 mole percent. The electron-transporting host material is further selected to have a host material vapor pressure, and the electron-transporting dopant material is further selected to have a dopant material vapor pressure in a range from 0.75 to 1.25 times the host material vapor pressure.

The solid homogeneous mixture of predoped organic electron-transporting material is then used in the evaporation source 160 (see FIG. 3) for sublimation or evaporation therefrom to form a doped organic electron-transporting layer over a doped organic light-emitting layer and, alternatively, over a doped organic hole-transporting layer, so as to provide either a tri-layer or a bilayer organic EL medium structure.

### EXAMPLES

The following examples are presented for a further understanding of the invention. For purposes of brevity, the materials and layers formed therefrom will be abbreviated as given below:
- Alq:: 8-Hydroxyquinoline, aluminum salt, also known as aluminum trisoxine; used in forming the electron-transporting layer 26
- ITO:: indium tin oxide, used in forming the light-trarismissive anode
- MgAg:: magnesium:silver at a ratio of 10:1 by volume, used in forming the cathode

- NPB:: 4,4'-bis[1-naphthyl)-N-phenylamino]-biphenyl; used in forming the hole-transporting layer

### Light-emitting host materials:

- ADN:: 9, 10-di(2-naphthyl) anthracene
- TBADN:: 2-tert-butyl-9, 10-di(2-naphthyl) anthracene

### Dopant materials:

- Rubrene:: a commercially available luminescent material
- TBP:: 2,5,8,11-tetra-tert-butylperylene

### Example 1. Preparation of predoped light-emitting materials BEM-1

A blue light-emitting predoped material BEM-1 was prepared by mixing the following mole percentages of solid materials: 49.5% ADN + 49.5% TBADN + 1% TBP, followed by melting the mixture in a container having a chemically inert environment. The homogeneous predoped light-emitting material was removed from the container upon cooling to ambient temperature. A portion on the predoped material was used in evaporation-depositing a doped light-emitting layer.

### Example 2. Preparation of predoped light-emitting materials BEM-2

A blue light-emitting predoped material BEM-2 was prepared by mixing the following mole percentages of solid materials: 99% TBADN + 1.0% TBP. This mixture was processed as described in Example 1, and a portion of this predoped material was used in evaporation-depositing a doped light-emitting layer.

### Example 3. Preparation of predoped light-emitting materials BEM-3

A blue light-emitting predoped material BEM-3was prepared by mixing the following mole percentages of solid materials: 95% TBADN + 5.0% TBP. This mixture was processed as described Example 2, and a portion of this predoped material was used in evaporation-depositing a doped light-emitting layer.

### Example 4. Preparation of predoped light-emitting materials YEM-1

A yellow light-emitting predoped material YEM-1 was prepared by mixing the following mole percentages of solid materials: 95% TBADN + 5% Rubrene. This mixture was processed as Example 3, and a portion of this predoped material was used in evaporation-depositing a doped light-emitting layer.

### Preparation of organic light-emitting devices (OLED) from predoped light-emitting materials

In each of the following examples, a light-transmissive ITO-coated glass plate was ultrasonicated in a commercial detergent, rinsed in deionized water, degreased in toluene evaporation, and contacted by a strong oxidizing agent.

### Example 5. Preparation of organic light-emitting device OLED-1A

a) a 150 nm thick NPB hole-transporting layer was deposited on the ITO by thermal evaporation deposition;
b) a 20 nm thick light-emitting layer was deposited over the NPB layer by thermal evaporation deposition of the BEM-1 predoped material from a evaporation deposition source (see FIG. 3);
c) a 37.5 nm thick Alq electron-transporting layer was deposited over the light-emitting layer by thermal evaporation deposition; and
d) a 200 nm thick MgAg cathode was deposited over the Alq layer by thermal evaporation co-deposition from two evaporation deposition sources (Mg and Ag).

The above OLED structure is abbreviated in Table II as ITO/NPB(150)/BEM-1(t)/Alq(37.5)MgAg(200)

### Example 6. Preparation of organic light-emitting device OLED-1B

This device was prepared by the same process steps as the device OLED-1A, except that a 25 nm thick light-emitting layer was deposited over the NPB layer.

### Example 7. Preparation of organic light-emitting device OLED-1

This device was prepared by the same process steps as the device OLED-1A, except that a 30 nm thick light-emitting layer was deposited over the NPB layer.

### Example 8. Preparation of organic light-emitting device OLED-2A, 2B, 2C and 2D

Four OLEDs were prepared sequentially by the following nominally identical process steps:
a) a 150 nm thick NPB hole-transporting layer was deposited on the ITO by thermal evaporation deposition;
b) a 20 nm thick light-emitting layer was deposited over the NPB layer by thermal evaporation deposition of the BEM-2 predoped material from a evaporation deposition source (see FIG. 3):
c) a 37.5 nm thick Alq electron-transporting layer was deposited over the light-emitting layer by thermal evaporation deposition; and
d) a 200 nm thick MgAg cathode was deposited over the Alq layer by thermal evaporation co-deposition from two evaporation deposition sources (Mg and Ag).

The above OLEDs structure is abbreviated in Table III as ITO/NPB(150)/BEM-2(20)/Alq(37.5)/MgAg (200)

### Example 9. Preparation of organic light-emitting device OLED-3A, 3B, 3C, 3D, 3E and 3F

Six OLEDs were prepared sequentially by the following nominally identical process steps:
a) a 150 nm NPB hole-transporting layer was deposited on the ITO by thermal evaporation deposition;
b) a 20 nm thick light-emitting layer was deposited over the NPB layer by thermal evaporation deposition of the YEM-1 predoped material from a evaporation deposition source (see FIG. 3);
c) a 37.5 nm thick Alq electron-transporting layer was deposited over the light-emitting layer by thermal evaporation deposition; and
d) a 200 nm thick MgAg cathode was deposited over the Alq layer by thermal evaporation co-deposition from two evaporation deposition sources (Mg and Ag).

The above OLED structure is abbreviated in Table IV as ITO/NPB(150)/YEM-1(20)/Alq(37.5)/MgAg(200)

For each prepared OLED, a drive voltage was applied to each device such that the cathode was at a more negative potential than the anode. The drive voltage was adjusted to provide a current density of 20 mA/cm². A luminous intensity of light-emission was measured, given as candela/m2 (cd/m²). A luminous efficiency was calculated from the luminous intensity and the current density, given as candela/ampere (cd/A). Color coordinates of the emitted light were measured, given by CIE x and CIE y. The wavelength of the peak of light-emission was measured, given as emission peak (EP) in nanometer (nm).

Test results are given in Tables I, II and III for the above described OLEDs.

**Table I.**

| **ITO/NPB(150)/BEM-1(20∼30)/Alq(37.5)MgAg(200)** | | | | | | | | |
|---|---|---|---|---|---|---|---|---|
| Device | BEM-1 Thickness (nm) | MA/cm² | V | cd/m² | cd/A | CIE x | CIE y | EP (nm) |
| OLED-1A | 20 | 20 | 7.3 | 585 | 2.92 | 0.145 | 0.214 | 464 |
| OLED-1B | 25 | 20 | 7.5 | 576 | 2.88 | 0.145 | 0.228 | 464 |
| OLED-1C | 30 | 20 | 7.5 | 571 | 2.86 | 0.147 | 0.244 | 464 |
| | | | | | | | | |

The results of devices in Table I show that an increasing BEM-1 layer thickness results in a slightly reduced luminous intensity, and in a shift to higher CIE y values.

**Table II.**

| **ITO/NPB(150)/BEM-2(20)/Alq(37.5)/MgAg (200)** | | | | | | | | |
|---|---|---|---|---|---|---|---|---|
| Device | BEM-1 Thickness (nm) | MA/cm² | V | cd/m² | cd/A | CIE x | CIE y | EP (nm) |
| OLED-2A | 20 | 20 | 7.6 | 571 | 2.86 | 0.146 | 0.226 | 464 |
| OLED-2B | 20 | 20 | 7.6 | 554 | 2.77 | 0.146 | 0.219 | 464 |
| OLED-2C | 20 | 20 | 7.5 | 5.7 | 2.88 | 0.146 | 0.213 | 464 |
| OLED-2D | 20 | 20 | 7.7 | 564 | 2.86 | 0.147 | 0.221 | 464 |

**Table III.**

| **ITO/NPB(150)/YEM-1(20)/Alq(37.5)/MgAg(200)** | | | | | | | | |
|---|---|---|---|---|---|---|---|---|
| Device | BEM-1 Thickness (nm) | MA/cm² | V | cd/m² | cd/A | CIE x | CIE y | EP (nm) |
| OLED-3A | 20 | 20 | 7.6 | 1017 | 5.08 | 0.476 | 0.509 | 564 |
| OLED-3B | 20 | 20 | 7.4 | 956 | 4.78 | 0.472 | 0.512 | 564 |
| OLED-3C | 20 | 20 | 7.5 | 927 | 4.63 | 0.472 | 0.512 | 564 |
| OLED-3D | 20 | 20 | 7.4 | 896 | 4.48 | 0.477 | 0.508 | 564 |
| OLED-3E | 20 | 20 | 7.5 | 860 | 4.30 | 0.477 | 0.508 | 564 |
| OLED-3F | 20 | 20 | 7.5 | 917 | 4.59 | 0.476 | 0.509 | 564 |

The results of devices in Tables II and III indicate substantial reproducibility among the respective sets of sequentially fabricated devices.

Other features of the invention are included below.

The predoped organic light-emitting material wherein the homogeneous solid mixture includes:
95 to 99.5 mole percent of organic light-emitting host material 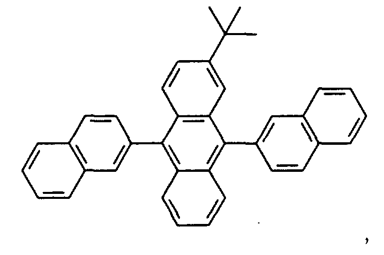 and
0.5 to 5 mole percent of light-emitting dopant materials

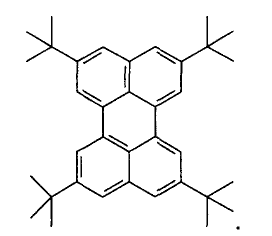

The predoped organic light-emitting material wherein the homogeneous solid mixture includes:
90 to 99 mole percent of the organic light-emitting host material 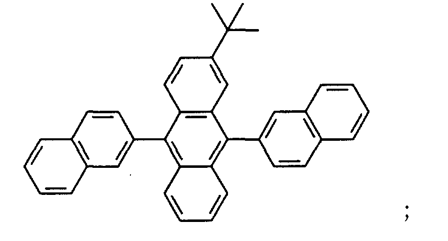 and
1 to 10 mole percent of light-emitting dopant materials

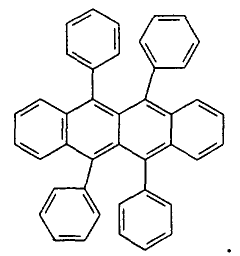

A method of depositing a predoped material to form a hole transporting layer in an organic light-emitting device, comprising the steps of:
(a) providing a homogeneous solid mixture capable of being deposited which includes at least one organic hole-transporting host material and at least one dopant material; and
(b) applying heat to evaporate the homogeneous solid mixture to form a hole transporting layer in an organic light emitting device.

A method of depositing a predoped material to form an electron-transporting layer in an organic light-emitting device, comprising the steps of:
(a) providing a homogeneous solid mixture capable of being deposited which includes at least one organic electron-transporting host material and at least one electron-transporting organic dopant material; and
(b) applying heat to evaporate the homogeneous solid mixture to form an electron-transporting layer in an organic light emitting device.

A method of making an organic light-emitting device having at least one doped organic layer, the method comprising the steps of:
(a) providing a light-transmissive substrate;
(b) forming a light-transmissive anode over the substrate;
(c) sequentially forming a multilayer organic electroluminescent (EL) medium structure over the anode;
(d) forming an cathode over the organic EL medium structure;
(e) providing a homogeneous solid mixture of a predoped organic material which includes at least one organic host material and at least one organic dopant material selected for forming the at least one doped organic layer of the organic EL medium structure; and
(f) forming the at least one doped organic layer by evaporating the homogeneous solid mixture of the predoped organic material from a evaporation deposition source.

The method wherein the providing step (e) includes the steps of:
(i) providing at least one solid organic host material having a host material vapor pressure, wherein the organic light-emitting host material includes one or more host components, each host component having a predetermined evaporation temperature T and one or more organic light-emitting dopant material, each organic light-emitting dopant material having an evaporation temperature in a range of from (T-40)°C to (T+40)°C;
(ii) mixing a selected quantity of the at least one host material and a selected quantity of the at least one dopant material; and
(iii) forming a homogeneous mixture of the selected quantities of the at least one host material and of the at least one dopant material.

The method wherein the homogeneous mixture forming step includes the steps of:
(i) melting a mixture of a selected quantity of at least one host material and of a selected quantity of at least one dopant material in a container having a chemically non-reactive environment;
(ii) cooling the homogeneous mixture to ambient temperature; and
(iii) removing the homogeneous mixture of the predoped organic light-emitting material from the container.

The method wherein the homogeneous mixture forming step includes the steps of:
(i) dissolving a mixture of a selected quantity of at least one host material and of a selected quantity of at least one dopant material in a solvent or in solvents within a container;
(ii) evaporating the solvent or solvents; and
(iii) removing the homogeneous mixture of the predoped organic light-emitting material from the container.

The method wherein the providing step e) includes the steps of:
(i) providing at least one solid organic hole-transporting host material, wherein the solid organic hole-transporting host material includes one or more components, each component having a predetermined evaporation temperature T and one or more organic light-emitting dopant material, each organic light-emitting dopant material having an evaporation temperature in a range of from (T-40)°C to (T+40)°C;
(ii) mixing a selected quantity of the at least one hole-transporting host material and a selected quantity of the at least one dopant material; and
(iii) forming a homogeneous mixture of the selected quantities of the at least one hole-transporting host material and of the at least one dopant material.

The method wherein the mixing step includes the step of:
mixing a selected quantity of at least one hole-transporting host material and a quantity of at least one hole-transporting dopant material selected to provide a dopant material concentration in the host material in a range from 1.0 to 50 mole percent.

The method wherein the providing step (e) includes the steps of:
(i) providing at least one solid organic hole-transporting host material, wherein the solid organic hole-transporting host material includes one or more components, each component having a predetermined evaporation temperature T and one or more organic light-emitting dopant material, each organic light-emitting dopant material having an evaporation temperature in a range of from (T-40)°C to (T+40)°C;
(ii) mixing a selected quantity of the at least one electron-transporting host material and a selected quantity of the at least one dopant material; and
(iii) forming a homogeneous mixture of the selected quantities of the at least one electron-transporting host material and the at least one dopant material.

The method wherein the mixing step includes the step of:
mixing a selected quantity of at least one electron-transporting host material and a quantity of at least one electron-transporting dopant material selected to provide a dopant material concentration in the host material in a range from 1.0 to 50 mole percent.

A method of making an organic light-emitting device having a doped light-emitting layer, the method comprising the steps of:
(a) providing a light-transmissive substrate;
(b) forming a light-transmissive anode over the substrate;
(c) forming an organic hole-transporting layer over the anode;
(d) providing a homogeneous solid mixture of a predoped organic light-emitting material which includes at least one organic light-emitting host material and at least one organic luminescent dopant material;
(e) forming a doped organic light-emitting layer over the hole-transporting layer by depositing the homogeneous solid mixture of the predoped organic light-emitting material from an evaporation deposition source;
(f) forming an organic electron-transporting layer over the light-emitting layer; and
(g) forming a cathode over the electron-transporting layer.

The method wherein the providing step (d) includes the steps of:
(i) providing at least one solid organic host material having a host material vapor pressure, wherein the organic light-emitting host material includes one or more host components, each host component having a predetermined evaporation temperature T and one or more organic light-emitting dopant material, each organic light-emitting dopant material having an evaporation temperature in a range of from (T-40)°C to (T+40)°C;
(ii) mixing a selected quantity of the at least one host material and a selected quantity of the at least one dopant material; and
(iii) forming a homogeneous mixture of the selected quantities of the at least one host material and of the at least one dopant material.

The method wherein the homogeneous mixture forming step includes the steps of:
(i) melting a mixture of selected quantity of at least one host material and of a selected quantity of at least one dopant material in a container having a chemically non-reactive environment;
(ii) cooling the homogeneous mixture to ambient temperature; and
(iii) removing the homogeneous mixture of the predoped organic light-emitting material from the container.

The method wherein the homogeneous mixture forming step includes the steps of:
(i) dissolving a mixture of a selected quantity of at least one host material and of a selected quantity of at least one dopant material in a evaporizable solvent or in evaporizable solvents within a container;
(ii) evaporating the solvent or solvents; and
(iii) removing the homogeneous mixture of the predoped organic light-emitting material from the container.

The method wherein the mixing step includes the step of:
mixing a selected quantity of at least one host material and a quantity of at least one dopant material selected to provide a dopant material concentration in the host material in a range from 0.05 to 5.0 mole percent.

## Claims

1. A method of depositing a predoped organic light emitting material to form a layer in an organic light-emitting device, comprising the steps of:
(a) providing a homogeneous solid mixture capable of being deposited which includes at least one organic light-emitting host material and at least one luminescent organic dopant material;
(b) depositing the homogeneous solid mixture to form a layer in an organic light emitting device; and
(c) wherein the organic light-emitting host material includes one or more host components, each host component having a predetermined evaporation temperature T and one or more organic light-emitting dopant material, each organic light-emitting dopant material having an evaporation temperature in a range of from (T-40)°C to (T+40)°C.

2. The predoped organic light-emitting material of claim 1 wherein the at least one luminescent organic dopant material has a concentration in the organic light-emitting host material in a range from 0.05 to 10.0 mole percent of the homogeneous solid mixture.

3. The predoped organic light-emitting material of claim 1 wherein the at least one organic light-emitting host material satisfies the structural formula: 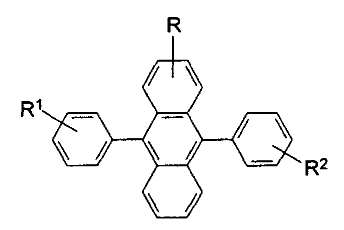 Wherein:
substituents R, R¹ and R² are each individually hydrogen, or alkyl of from 1 to 24 carbon atoms; alkoxyl of from 1 to 24 carbon atoms; aryl or
substituted aryl of from 5 to 20 carbon atoms; or heteroaryl or substituted heteroaryl of from 5 to 24 carbon atoms; or fused aryl groups containing from 4 to 12 carbon atoms; or fluorine, chlorine, bromine; or a cyano group.

4. The predoped organic light-emitting material of claim 3 wherein the organic light-emitting host materials are selected from the group consisting of: 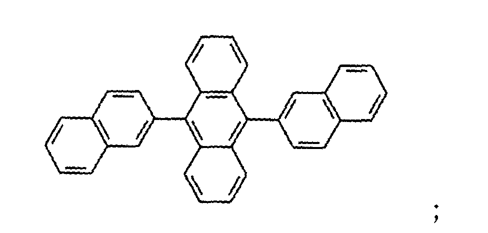 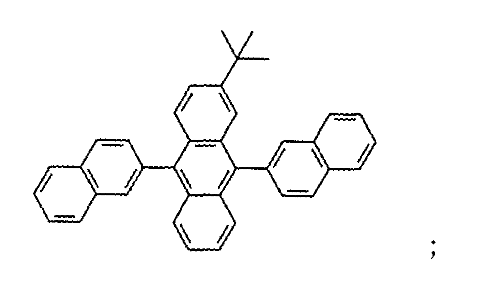 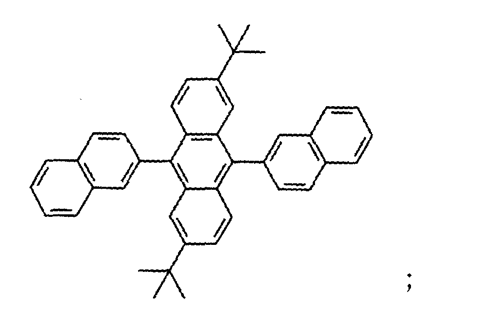 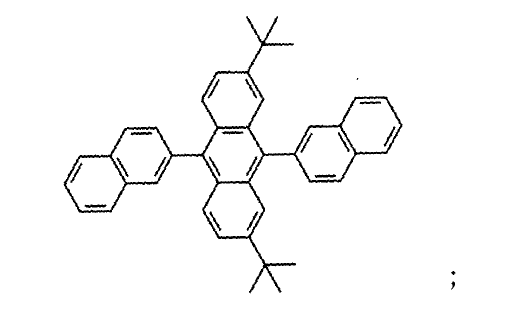 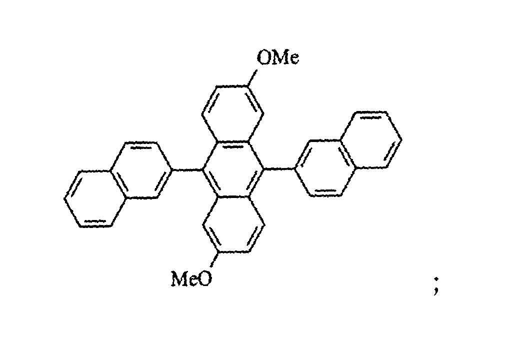 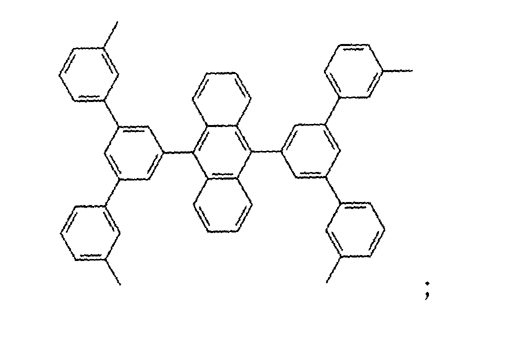 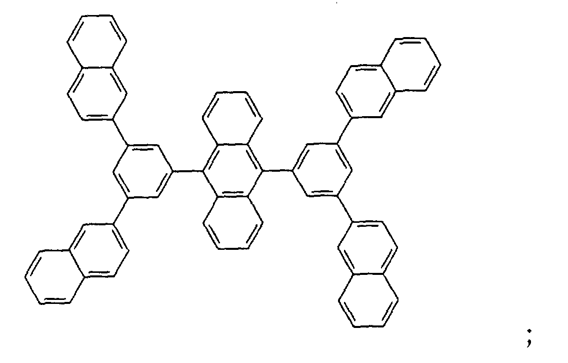 and

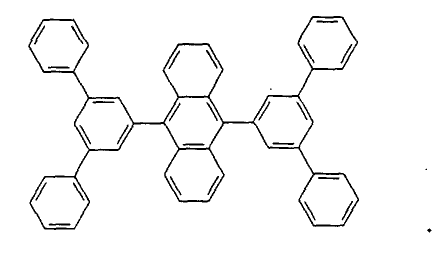

5. The predoped organic light-emitting material of claim 1 wherein the at least one organic light-emitting host material satisfies the structural formula: 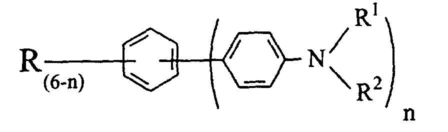 Wherein:
n is unequal to 1, 2, 3, 4, 5, or 6;
R¹ and R² are individually aryl or substituted aryl of from 5 to 20 carbon atoms; or heteroaryl or substituted heteroaryl of from 5 to 24 carbon atoms; or fused aryl groups containing from 4 to 12 carbon atoms;
R is selected from group consisting of hydrogen and alkyl of from 1 to 24 carbon atoms.

6. The predoped organic light-emitting material of claim 5 wherein the organic light-emitting host materials are selected from the group consisting of:

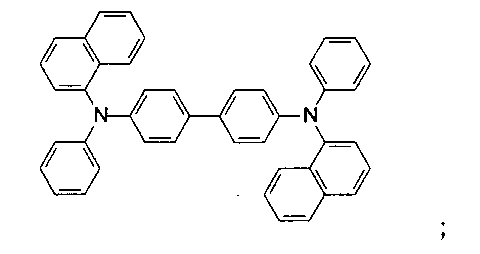

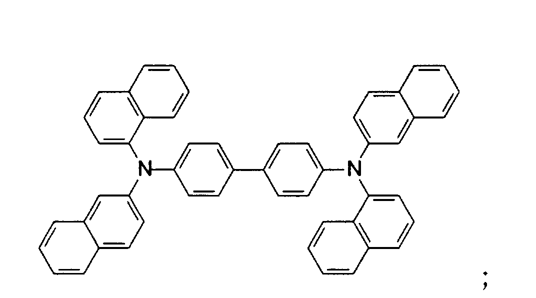

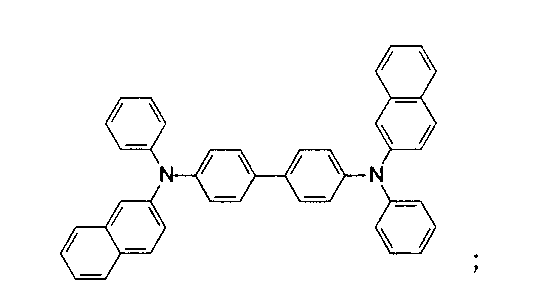

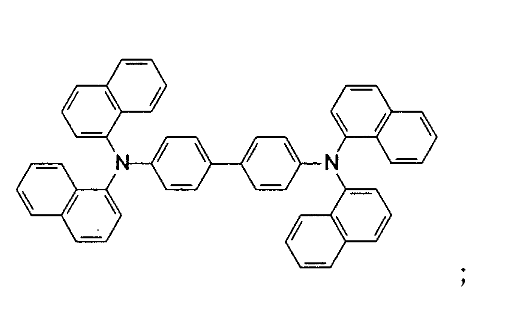

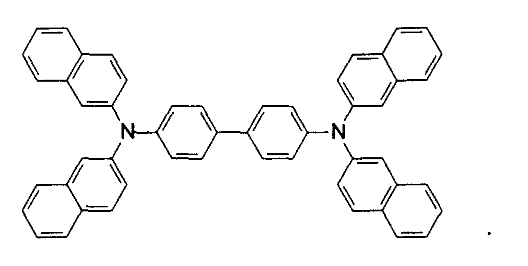

7. The predoped organic light-emitting material of claim 1 wherein the at least one organic light-emitting dopant material satisfies the structural formula: 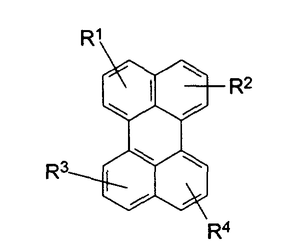 Wherein:
substituents R¹, R², R³ and R⁴ are each individually hydrogen, or alkyl of from 1 to 24 carbon atoms; alkoxyl of from 1 to 24 carbon atoms; aryl or substituted aryl of from 5 to 20 carbon atoms; or heteroaryl or substituted heteroaryl of from 5 to 24 carbon atoms; or fused aryl groups containing from 4 to 12 carbon atoms; or fluorine, chlorine, bromine; or a cyano group.

8. The predoped organic light-emitting material of claim 7 wherein the organic light-emitting dopant materials are selected from the group consisting of: 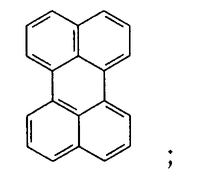 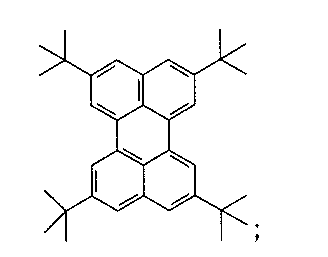 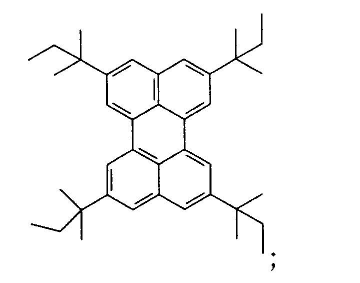 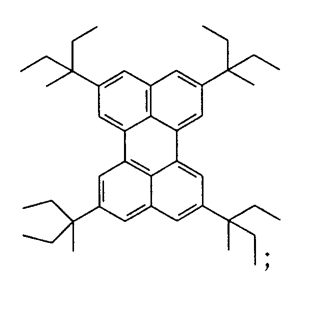 and

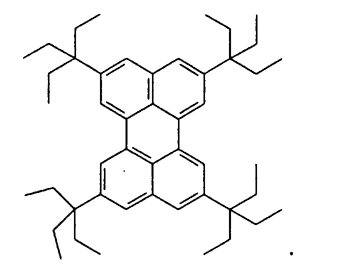

9. The predoped organic light-emitting material of claim 1 wherein at least one organic light-emitting dopant material satisfies the structural: 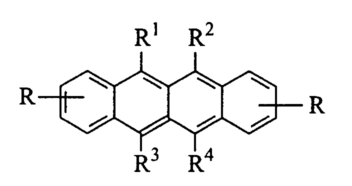 Wherein:
substituents R is each individually hydrogen, or alkyl of from 1 to 24 carbon atoms; alkoxyl of from 1 to 24 carbon atoms; R¹, R², R³ and R⁴ are each individually aryl or substituted aryl of from 5 to 20 carbon atoms; or heteroaryl or substituted heteroaryl of from 5 to 24 carbon atoms; or fused aryl groups containing from 4 to 12 carbon atoms.

10. The predoped organic light-emitting material of claim 9 wherein the organic light-emitting dopant materials are selected from the group consisting of: 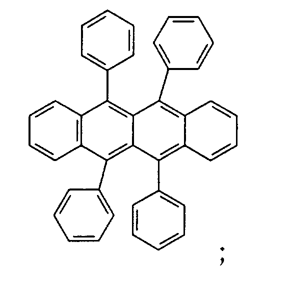 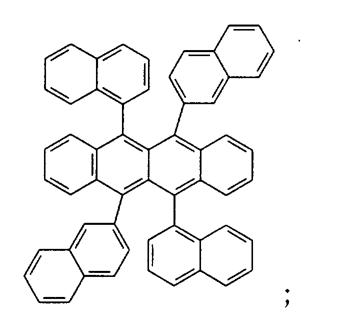 and
